# EUROPÄISCHE PATENTSCHRIFT

(11) **EP 2 253 185 B1**
(45) Veröffentlichungstag und Bekanntmachung des Hinweises auf die Patenterteilung: **21.09.2011**
(21) Anmeldenummer: 09718897.3
(22) Anmeldetag: 11.03.2009
(51) Int. Cl.: H05K 5/00, H01R 9/22, H01L 31/048

(54) **VERBINDUNGSBOX FÜR SOLAR-MODULE UND VERFAHREN ZU DEREN MONTAGE AN DEN MODULEN**
JUNCTION BOX FOR SOLAR-MODULES AND METHOD FOR THE MOUNTING THEREOF ON SAID MODULES
BOÎTE DE JONCTION POUR MODULES SOLAIRES ET PROCÉDÉ DE MONTAGE DE LA BOÎTE DE JONCTION SUR LESDITS MODULES

(30) Priorität: 13.03.2008 DE 102008013930; 06.05.2008 DE 102008022297
(43) Veröffentlichungstag der Anmeldung: 24.11.2010
(73) Patentinhaber: FPE Fischer Gmbh, 88299 Leutkirch (DE)
(72) Erfinder: PFEFFER, Roland, 88299 Leutkirch (DE)
(74) Vertreter: Kaufmann, Sigfrid
(86) Internationale Anmeldenummer: PCT/DE2009/000331
(87) Internationale Veröffentlichungsnummer: WO 2009/112019

(56) Entgegenhaltungen:
- DE-B3- 10 334 935
- DE-T5-112005 002 898
- DE-U1- 20 311 183
- DE-U1-202005 018 884
- US-A1- 2001 050 102

## Beschreibung

Die Erfindung betrifft eine Verbindungsbox, die eine vollautomatische Montage an allen handelsüblichen Solar-Modulen ermöglicht. Die Box kann zudem automatisch bestückt werden. Mit dem Verfahren wird die Box in unkomplizierter Weise auf der Rückseite des Solar-Moduls positioniert und elektrisch mit diesem verbunden.

Aus dem Stand der Technik sind Verbindungsboxen bekannt, die der elektrischen Anbindung der einzelnen Solar-Module in der Solaranlage dienen. Die Verbindungsboxen werden auf den Rückseiten der Solar-Module befestigt. In den Boxen sind Bypassdioden (bzw. Leistungshalbleiter mit derselben Funktion) untergebracht, die die Solar-Module im Falle einer teilweisen Abschattung vor einer lokalen Überhitzung (hot spot) schützen.

Da immer mehr Solaranlagen eingesetzt werden, steigt die Nachfrage an Verbindungsboxen. Gleichzeitig wächst der Kostendruck infolge EEG-Degression. Parallel dazu steigen die Anforderungen an die Qualität der Boxen, da immer leistungsfähigere Solar-Module zum Einsatz kommen. In größeren Solaranlagen treten höhere Sperrströme auf, die eine verbesserte Entwärmung der Bypassdioden durch die Verbindungsboxen erforderlich machen.

Zurzeit ist es üblich, die Verbindungsboxen von Hand auf den Solar-Modulen zu montieren. Auch die Bestückung der Verbindungsboxen erfolgt meist manuell. Da aus o.g. Gründen der Zeit- und Kostendruck immer mehr zunimmt, ist es jedoch dringend erforderlich, dass Verfahren gefunden werden, mit denen beide Arbeitsschritte vollautomatisch durchgeführt werden können. Die angestrebte Automatisierung darf jedoch nicht zulasten der Qualität der Verbindungsboxen gehen, insbesondere dürfen keine Mittel eingesetzt werden, die die Entwärmung der Bypassdioden beeinträchtigen.

Für die vollautomatische Bestückung der Verbindungsboxen käme an sich die Verwendung von Elektronikplatinen in Betracht. Deren Einsatz verbietet sich jedoch, da die Platinen aufgrund der hohen Temperaturschwankungen, die während des Betriebs in den Verbindungsboxen auftreten, brechen oder zumindest Kontaktprobleme verursachen würden.

Aus dem Stand der Technik sind neuerdings verschiedene Bestrebungen bekannt, Verbindungsboxen mit wenig Aufwand an den Solar-Modulen zu montieren, die zuvor weitgehend automatisch bestückt wurden.

So wird in DE 101 54 234 A1 eine Anordnung aus einem paneelartigem (Solar-) Modul und einer Anschlusseinheit (Verbindungsbox) offenbart, die miteinander verklebt sowie mit Hilfe von Anschlussabschnitten elektrisch verbunden werden. In der Anschlusseinheit befindet sich ein elektrisch leitendes Stanzgitter mit bereits ausgeformten Anschlussabschnitten. Das Stanzgitter ist zunächst einteilig ausgeführt, wobei dessen einzelne Abschnitte durch Brücken zusammengehalten werden. Die elektronischen Bauteile sowie ggf. Anschlusskabel werden mit dem Stanzgitter verschweißt. Anschließend werden die Brücken entfernt. Das Stanzgitter wird zusammen mit den Bauteilen in Kunststoff eingegossen, wobei die Anschlussabschnitte frei bleiben. Bei der Montage der Anschlusseinheit auf dem Solar-Modul werden die Leitungen des Solar-Moduls an die Anschlussabschnitte geschweißt oder gelötet.

Die Vereinfachung in der Montage und Bestückung geht jedoch zulasten der Qualität der Anschlusseinheit: die Bypassdioden sind im Inneren des Vergusskörpers angeordnet und können die von ihnen erzeugte Wärme praktisch nur über die Anschlussdrähte und das Stanzgitter abgeben. Die Entwärmung durch die Anschlusseinheit ist also unzureichend. Auch ist das Entfernen der Brücken des Stanzgitters aufwendig. Des Weiteren macht der Ausfall eines der eingegossenen elektronischen Bauteile einen Wechsel der kompletten Anschlusseinheit erforderlich.

Der Erfindung liegt die Aufgabe zugrunde, die Nachteile des Standes der Technik zu beseitigen.

Insbesondere soll eine Verbindungsbox geschaffen werden, die vollautomatisch an allen handelsüblichen Solar-Modulen montiert werden kann. Mit dem Verfahren soll es auf unkomplizierte Weise möglich sein, die Box auf der Rückseite des Solar-Moduls zu positionieren und elektrisch mit diesem zu verbinden.

Diese Aufgabe wird erfindungsgemäß durch die Merkmale der Ansprüche 1 und 6 gelöst. Weitere vorteilhafte Ausführungen bezüglich der Verbindungsbox ergeben sich aus den Ansprüchen 2 bis 5 sowie 10 und 11.

Ausgegangen wird von einer Verbindungsbox mit einem Gehäuse, in dem Bypassdioden sowie die notwendigen elektrischen Verbindungen, die Anschlussenden aufweisen, eingebracht sind. Nach Maßgabe der Erfindung umfasst die Verbindungsbox einen Positionierblock, der Aufnahmenuten für die Flachbandleitungen der Solar-Module aufweist, wobei die Nuten an die Form der Flachbandleitungen angepasst sind. Am Gehäuse oder am Gehäusedeckel ist ein Niedehalter angebracht, der bei montierter Verbindungsbox sowohl die Flachbandleitungen als auch die an den Anschlussenden befestigten Kontaktklammern in die Nuten des Positionierblocks presst.

Der Positionierblock verfügt über Führungsstifte; im Gehäuse befinden sich Aussparungen, in die diese Führungsstifte greifen können. So kann das Gehäuse durch einfaches Aufstecken positioniert werden. Die Stifte rasten mittels Clips in das Gehäuse der Box ein, wodurch eine sichere Verbindung hergestellt wird.

Bei einer Variante der Verbindungsbox, die besonders schnell und unkompliziert am Solar-Modul montiert werden kann, tragen die Anschlussenden Kontaktklammern, die bei montierter Box die Flachbandleitungen umfassen. Der elektrische Kontakt mit dem Solar-Modul wird automatisch beim Aufkleben des Gehäuses der Box hergestellt. Die Klammern und die Flachbandleitungen werden durch einen Niederhalter fest in die Nuten des Positionierblocks gepresst. In jeder der Nuten befinden sich zwei Aussparungen, welche die beiden Zungen der Kontaktklammem aufnehmen.

Da einige Hersteller von Solar-Modulen in ihren Spezifikationen fordern, dass die Anschlussleitungen ihrer Module mit denen der Verbindungsboxen verlötet oder verschweißt werden, sind deshalb in einer weiteren Varianten bei montierter Verbindungsbox die Anschlussenden und die Flachbandleitungen in die Nuten des Positionierblocks eingebracht sowie miteinander verlötet oder verschweißt. An der innen liegenden Seite des Gehäusedeckels ist ein Kunststoffdeckel befestigt, der den Positionierblock vollständig überdeckt. Im Kunststoffdeckel befindet sich ein Niederhalter, der die Anschlussenden und die Flachbandleitungen in die Nuten des Positionierblocks presst.

Die elektrischen Verbindungen der Box bestehen aus ausgestanzten Leiterbahnen, die mit Kunststoff ummantelt sind. Dabei ist es vorgesehen, die Leiterbahnen mit je zwei Halbschalen aus Kunststoff zu umgeben.

Durch den Einsatz der ausgestanzten Leiterbahnen wird eine vollautomatische Bestückung der Verbindungsbox ermöglicht. Im Gegensatz zu Elektronikplatinen halten die ausgestanzten Leiterbahnen auch hohen Temperaturschwankungen stand.

Dem erfindungsgemäßen Verfahren zur Montage der Verbindungsboxen an Solar-Modulen folgend, wird zuerst ein Positionierblock auf das Solar-Modul aufgeklebt. Die Flachbandleitungen werden in die dafür vorgesehenen Nuten eingelegt.

Als nächstes wird das Gehäuse der Verbindungsbox zum Solar-Modul ausgerichtet, indem die Führungsstifte des Positionierblocks in die entsprechend geformten Aussparungen im Gehäuse eingeschoben werden.

Schließlich wird das Gehäuse auf das Solar-Modul aufgeklebt. Nach dem Aufkleben ist der Positionierblock vollständig vom Gehäuse umschlossen. Damit ist dieser vor Witterungseinflüssen geschützt. Außerdem ist sichergestellt, dass keine Leitungen freiliegen, von denen die Gefahr eines Stromschlags durch unbeabsichtigtes Berühren ausgeht.

Abhängig davon, welche Variante der Verbindungsbox zum Einsatz kommt, wird der elektrische Kontakt zwischen den Anschlussenden und den Flachbandleitungen des Solar-Moduls entweder automatisch beim Aufkleben mittels Kontaktklammem oder in einem nachfolgenden Schritt durch Löten bzw. Schweißen hergestellt.

Die Montage des Gehäuses der Verbindungsbox mit Kontaktklammern erfolgt bei geschlossenem Gehäusedeckel. Beim Aufkleben wird das Gehäuse auf die Rückseite des Solar-Moduls gedrückt. Dadurch werden die Kontaktklammern durch den Niederhalter auf die in den Nuten des Positionierbocks liegenden Flachbandleitungen gepresst. Die Klammem umfassen die Flachbandleitungen, sodass ein guter elektrischer Kontakt gewährleistet wird.

Zur Montage der Verbindungsboxen an Modulen, bei denen ein Verlöten oder Verschweißen der Anschlussleitungen vorgeschrieben ist, wird das Gehäuse der Verbindungsbox zunächst ohne Gehäusedeckel auf das Solar-Modul geklebt. Der Positionierblock mit den aufgelegten Flachbandleitungen des Solar-Moduls ragt durch eine Aussparung im Boden des Gehäuses. Die Flachbandleitungen werden mit den Anschlussenden der Verbindungsbox verlötet oder verschweißt. Schließlich wird das Gehäuse mit dem Deckel verschlossen.

Die erfindungsgemäße Verbindungsbox wird nachfolgend anhand eines Ausführungsbeispiels näher erläutert; hierzu zeigen:

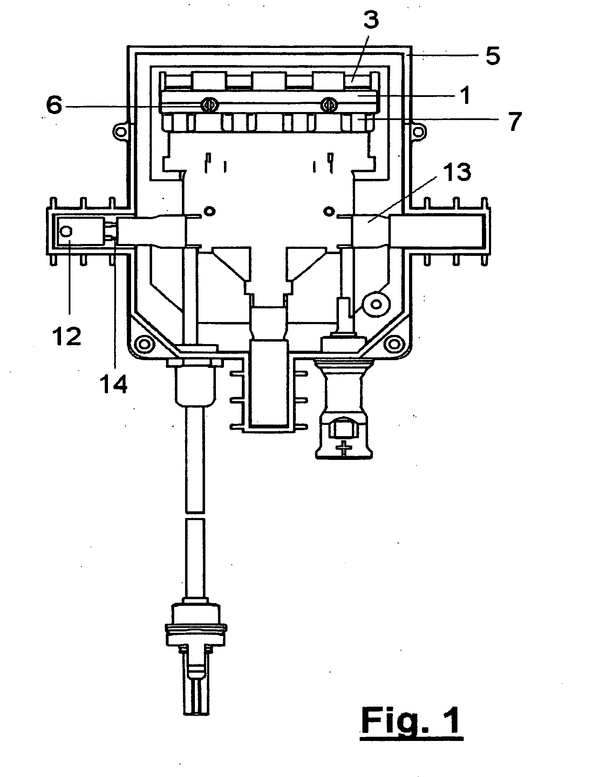

- Fig. 1:: eine geöffnete Verbindungsbox mit Positionierblock in Draufsicht,
- Fig. 2:: einen auf einem Solar-Modul montierten Positionierblock in Draufsicht,
- Fig. 3:: einen Positionierblock mit Flachbandleitungen und Anschlussenden der Verbindungsbox bei einer elektrischen Verbindung mit Kontaktklam- mern in seitlicher Schnittdarstellung,
- Fig. 4:: einen Positionierblock mit Flachbandleitungen und Anschlussenden der Verbindungsbox bei einer durch Löten oder Schweißen hergestellten elektrischen Verbindung in seitlicher Schnittdarstellung.

Die Verbindungsbox kann an allen handelsüblichen Solar-Modulen 4 vollautomatisch montiert werden. Um die Kompatibilität mit den verschiedenen Bauformen zu erreichen, sind individuelle, aus Kunststoff gefertigte Positionierblöcke 1 vorgesehen. Die elektrische Verbindung zwischen der Verbindungsbox und dem Solar-Modul 4 ist durch die Kontaktklammern 8 hergestellt. Wie oben ausgeführt, ist es auch möglich, die Verbindungsbox mit dem Solar-Modul 4 durch Löten oder Punktschweißen zu verbinden.

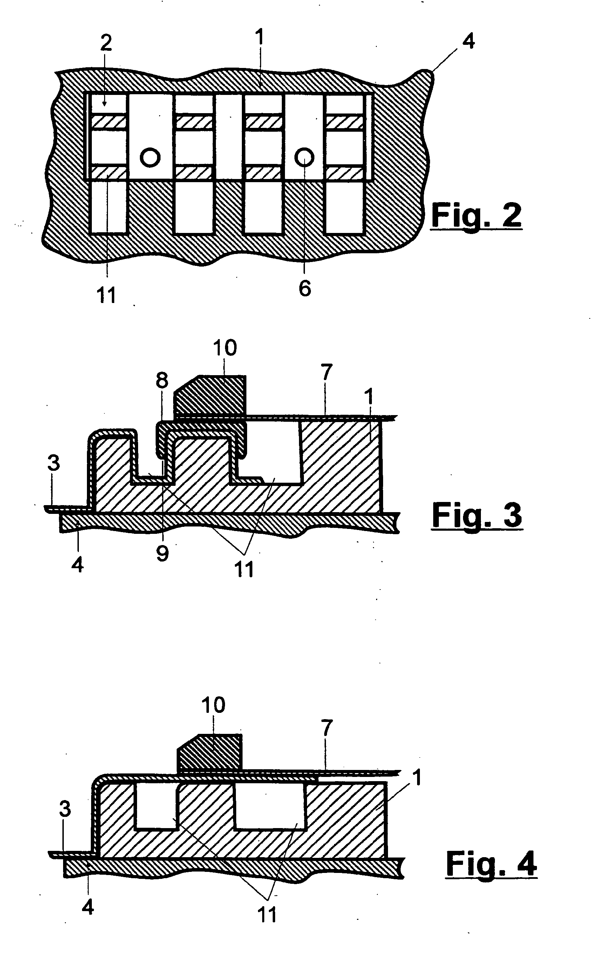

Zum Anschluss der Verbindungsbox an das Solar-Modul 4 mittels der Kontaktklammem 8 wird zuerst der Positionierblock 1 auf die Rückseite des Solar-Moduls 4 mit Silikonkleber oder doppelseitigem Klebeband geklebt (s. Fig. 2/3). Die Flachbandleitungen 3 des Moduls werden so zurechtgebogen, dass sie in den dafür vorgesehenen Nuten 2 des Positionierblocks 1 liegen. Anschließend wird das geschlossene Gehäuse 5 durch die Führungsstifte 6 des Positionierblocks 1 zum Solar-Modul 4 positioniert und das Gehäuse 5 mit dem Modul 4 verklebt. Die Stifte 6 rasten mittels Clips in Aussparungen des Gehäuses 5 ein, wodurch eine sichere Verbindung hergestellt wird, ohne dass das Solar-Modul mechanisch belastet wird. Beim Aufbringen des Gehäuses 5 greifen Kontaktklammern 8 über die Flachbandleitungen 3, wobei die Klammern 8 durch einen in der Innenseite des Gehäusedeckels integrierten Niederhalter 10 auf die Flachbandleitungen3 gepresst werden. Die Zungen 9 der Kontaktklammer 8 werden von den Aussparungen 11, die in den Nuten 2 eingebracht sind, aufgenommen (s. Fig. 3).

Zur Anbindung des Moduls 4 durch Löten oder Punktschweißen wird gleichfalls mit dem Ankleben des Positionierblocks 1 und dem Einlegen der Flachbandleitungen 3 in die Nuten 2 des Positionierblocks 1 begonnen. Anschließend wird das Gehäuse 5 (zunächst ohne Deckel) mit Silikonkleber oder doppelseitigem Klebeband auf dem Solar-Modul 4 angebracht. Die Flachbandleitungen 3 werden an die Anschlussenden 7 gelötet oder geschweißt. Der Positionierblock 1 gewährleistet dabei einen ausreichenden Abstand zur Modulrückwand und sichert gleichzeitig den Abstand zwischen den Flachbandleitungen 3. Beim Schließen des Gehäuses 5 werden die Flachbandleitungen 3 mit dem in der Innenseite des Gehäusedeckels integrierten Niederhalter 10 in die Nuten 2 des Positionierblocks 1 gedrückt und somit fixiert (s. Fig. 4). Der Kunststoffdeckel ist an der Innenseite des Gehäusedeckels angebracht, sodass der Positionierblock 1 beim Schließen des Gehäusedeckels mit dem Kunststoffdeckel überdeckt wird.

Die elektrische Verdrahtung der Verbindungsbox besteht aus ausgestanzten Leiterbahnen aus Kupfer, die über die gesamte Länge, mit Ausnahme der Anschlussenden 7, vollständig von je zwei profilartigen Kunststoff-Halbschalen 13 ummantelt sind. Die Halbschalen 13 sind entweder im Gehäuse 5 integriert oder sind als separate Baugruppen ausgeführt. Auf diese Weise erreicht die Verbindungsbox problemlos die elektrische Schutzklasse 2.

Die Bypassdioden 12 sind mit den ausgestanzten Leiterbahnen durch die Steckkontakte 14 verbunden, wobei die Leiterbahnen als Buchsen und die Anschlussdrähte der Dioden 12 als Stecker wirken. Dieser Aufbau ermöglicht es, defekte Bypassdioden 12 ohne großen Aufwand zu wechseln; nach Abschrauben des Gehäusedeckels muss lediglich die Diode 12 mitsamt der Isolierung aus den Steckkontakten herausgezogen und ausgetauscht werden.

### Liste der verwendeten Bezugszeichen

- 1: Positionierblock
- 2: Nut
- 3: Flachbandleitungen
- 4: Solar-Modul
- 5: Gehäuse
- 6: Führungsstift
- 7: Anschlussende
- 8: Kontaktklammer
- 9: Zunge
- 10: Niederhalter
- 11: Aussparung
- 12: Bypassdiode
- 13: Halbschale
- 14: Steckkontakt

## Patentansprüche

1. Verbindungsbox mit einem Gehäuse (5), in dem Bypassdioden (12) sowie notwendige elektrische Verbindungen eingebracht sind, wobei die elektrischen Verbindungen Anschlussenden (7) aufweisen, die dem Anschluss der Flachbandleitungen (3) des Solar-Moduls (4) dienen, **dadurch gekennzeichnet, dass** die Anschlussenden (7) mit Kontaktklammern (8) verbunden sind, die zwei Zungen (9) besitzen und bei montierter Box die Flachbandleitungen (3) umschließen, und die Verbindungsbox einen Positionierblock (1) umfasst, in dem Aufnahmenuten (2) für die Flachbandleitungen (3) des Solar-Moduls (4) ausgeformt sind, wobei die Form der Aufnahmenuten (2) an die Form der Flachbandleitungen (3) angepasst, jede Nut (2) mit zwei Aussparungen (11) versehen und am Gehäuse (5) oder dessen Deckel ein Niederhalter (10) angebracht ist, der die Flachbandleitungen (3), die Anschlussenden (7) und die Klammem (8) in die Nuten (2) des Positionierblocks (1) einpresst, wobei die beiden Zungen (9) der Klammem (8) von jeweils einer der beiden Aussparungen (11) aufgenommen werden.

2. Verbindungsbox nach Anspruch 1, **dadurch gekennzeichnet, dass** der Positionierblock (1) Führungsstifte (6) aufweist, die bei montierter Box in Aussparungen des Gehäuses (5) eingreifen.

3. Verbindungsbox nach Anspruch 1 und 2, **dadurch gekennzeichnet, dass** die elektrischen Verbindungen mit Kunststoff ummantelte, ausgestanzte Leiterbahnen sind.

4. Verbindungsbox nach Anspruch 1 bis 3, **dadurch gekennzeichnet, dass** die Leiterbahnen mittels zweier Halbschalen (13) aus Kunststoff ummantelt sind.

5. Verbindungsbox nach Anspruch 3 und 4, **dadurch gekennzeichnet, dass** die Bypassdioden (12) und die Leiterbahnen durch Steckkontakte (14) verbunden sind.

6. Verfahren zur Montage von Verbindungsboxen an Solar-Modulen, **dadurch gekennzeichnet, dass** es die Schritte
- Aufkleben des Positionierblockes (1) und Einlegen der Flachbandleitungen in die Nuten (2) und ,
- Ausrichten der Verbindungsbox mit Hilfe der Führungsstifte (6) durch Einschieben in die Aussparungen im Gehäuse (5),
- Aufkleben des Gehäuses (5) im geschlossenen Zustand auf das Solar-Modul (4) derart, dass der Positionierblock (1) vollständig vom Gehäuse (5) umschlossen wird und die Kontaktklammern (8) durch den Niederhalter (10) auf die Flachbandleitungen (3) gepresst werden und die Klammern (8) die Flachbandleitungen (3) umgreifen, wodurch ein elektrischer Kontaktzwischen den Flachbandleitungen (3) und den Anschlussenden (7) hergestellt wird,
umfasst.

## Claims

1. A junction box with a housing (5), in which bypass diodes (12) and necessary electrical connections are accommodated, wherein the electrical connections possess connection ends (7) serving for connection of the flat conductors (3) of the solar module (4), **characterised in that** the connection ends (7) are connected with contact clamps (8) which possess two legs (9) and enclose the flat conductors (3) when the box is mounted, and the junction box comprises a positioning block (1) in which receiving slots (2) for the flat conductors (3) of the solar module (4) are formed, said form of the receiving slots (2) being matched to the form of the flat conductors (3), each slot (2) is provided with two recesses (11) and a hold-down device (10) is mounted on the housing (5) or housing cover to press the flat conductors (3), the connection ends (7) and the clamps (8) into the slots (2) of the positioning block (1), the two legs (9) of the clamps (8) each being received by one of the two recesses (11).

2. A junction box according to Claim 1, **characterised in that** the positioning block (1) possesses locating pins (6) which engage in recesses in the housing (5) when the box is mounted.

3. A junction box according to Claims 1 and 2, **characterised in that** the electrical connections are stamped conductor tracks encased with plastic.

4. A junction box according to Claims 1 to 3, **characterised in that** the conductor tracks are encased by way of two half-shells (13) made of plastic.

5. A junction box according to Claims 3 and 4, **characterised in that** the bypass diodes (12) and the conductor tracks are connected by way of plug-in contacts (14).

6. A method for the mounting of junction boxes on solar modules, **characterised in that** it comprises the steps
- attaching of the positioning block (1) and insertion of the flat conductors (3) in the slots (2),
- alignment of the junction box with the aid of the locating pins (6) by pushing said pins into recesses in the housing (5),
- attaching of the closed housing (5) on the solar module (4) in such a manner that the positioning block (1) is fully enclosed by the housing (5) and the contact clamps (8) are pressed onto the flat conductors (3) by the hold-down device (10) and the clamps (8) embrace the flat conductors (3), thus producing an electrical contact between the flat conductors (3) and the connection ends (7).

## Revendications

1. Boîte de connexion comportant un boîtier (5) abritant des diodes by-pass (12) et les liaisons électriques nécessaires, les liaisons électriques présentant des extrémités de raccordement (7) destinées au raccordement des câbles plats (3) du module solaire (4), **caractérisée en ce que** les extrémités de raccordement (7) sont reliées à des pinces de contact (8) qui possèdent deux languettes (9) entourant les câbles plats (3) lorsque la boîte est installée, et que la boîte de connexion comprend un bloc de positionnement (1) muni de rainures de logement (2) pour les câbles plats (3) du module solaire (4), la forme des rainures de logement (2) étant adaptée à la forme des câbles plats (3), chaque rainure (2) possédant deux évidements (11), un serre-câbles (10) étant fixé au boîtier (5) ou à son couvercle pour maintenir les câbles plats (3), les extrémités de raccordement (7) et les pinces (8) dans les rainures (2) du bloc de positionnement (1), les deux languettes (9) des pinces (8) étant logées chacune dans l'un des deux évidements (11).

2. Boîte de connexion selon la revendication 1, **caractérisée en ce que** le bloc de positionnement (1) est muni de broches de guidage (6) qui s'engagent dans des évidements du boîtier (5) lorsque la boîte est installée.

3. Boîte de connexion selon les revendications 1 et 2, **caractérisée en ce que** les liaisons électriques sont des circuits conducteurs poinçonnés, enveloppés de matière plastique.

4. Boîte de connexion selon les revendications 1 à 3, **caractérisée en ce que** les circuits conducteurs sont entourés de deux demi-coques (13) en matière plastique.

5. Boîte de connexion selon les revendications 3 et 4, **caractérisée en ce que** les diodes by-pass (12) et les circuits conducteurs sont reliés par des contacts enfichables (14).

6. Procédé de montage de boîtes de connexion sur des modules solaires, **caractérisé en ce qu'**il consiste
- à coller le bloc de positionnement (1) et à poser les câbles plats dans les rainures (2),
- à aligner la boîte de connexion en engageant les broches de guidage (6) dans les évidements du boîtier (5),
- à coller le boîtier (5) à l'état fermé sur le module solaire (4) de sorte que le bloc de positionnement (1) soit entièrement enveloppé par le boîtier (5) et que le serre-câbles (10) plaque les pinces de contact (8) contre les câbles plats (3) et que les pinces (8) entourent les câbles plats (3) de manière à établir un contact électrique entre les câbles plats (3) et les extrémités de raccordement (7).
